Europäisches Patentamt

European Patent Office

Office européen des brevets

(19)

(11) Publication number: **0 164 737 B1**

(12) **EUROPEAN PATENT SPECIFICATION**

(45) Date of publication of patent specification: **18.09.91** (51) Int. Cl.⁵: **H01L 21/31, H01L 21/82, H01L 21/28, H01L 29/08**

(21) Application number: **85107216.5**

(22) Date of filing: **12.06.85**

(54) **A method of fabricating self-aligned regions in a substrate.**

(30) Priority: **15.06.84 US 620835**
**22.08.84 US 643362**

(43) Date of publication of application:
**18.12.85 Bulletin 85/51**

(45) Publication of the grant of the patent:
**18.09.91 Bulletin 91/38**

(84) Designated Contracting States:
**DE FR GB IT NL**

(56) References cited:
**EP-A- 0 054 259**
**EP-A- 0 074 215**
**US-A- 4 435 896**

**IBM TECHNICAL DISCLOSURE BULLETIN, vol. 25, no. 6, page 2730, November 1982, New York, US; J. GRESCHNER et al.: "Process for image reversal"**

(73) Proprietor: **HARRIS CORPORATION**
**P.O. Box 37**
**Melbourne, FL 32919(US)**

(72) Inventor: **Gasner, John T.**
**634 Ford Circle West**
**Melbourne Florida 32935(US)**
Inventor: **Hause, Frederick N.**
**3769 Jupiter Boulevard, S.E.**
**Palm Bay Florida 32905(US)**

(74) Representative: **Dauster, Hanjörg, Dipl.-Ing.**
**WILHELM & DAUSTER Patentanwälte**
**Hospitalstrasse 8**
**W-7000 Stuttgart 1(DE)**

## Description

### BACKGROUND AND SUMMARY OF THE INVENTION

The present invention relates to a method of fabricating self-aligned regions in a substrate.

The industry is constantly working toward increasing the device density on a wafer or chip. The number of devices that can be placed on a chip is limited by the size of the device and the electrical interaction. These place restraints on the spacing between devices. Further limitation are in the processing steps dealing with photolithography and the ability to form doped regions of the controllable size and impurity concentration. For junction isolated insulated gate field effect transistors, the design must minimize device latch-up resulting from parasitic bipolar devices. It is also desirable to reduce the capacitance of the device as well as the contact and interconnect system. Hot electron and the substrate current injection is another problem which must be faced for insulated gate field effect transistors as well as reducing the resistance of the contacts and junctions.

In CMOS integrated circuit processes, where complementary transistors are the basic building blocks of complex circuits, doping concentration backgrounds of both N and P backgrounds need to exist for fabricating the transistors. Previous processes used only one photolithographic mask to implant an impurity to change impurity type in the silicon, or other type of substrate, for the well of one transistor while the background doping of the substrate would be the well of the complementary transistor.

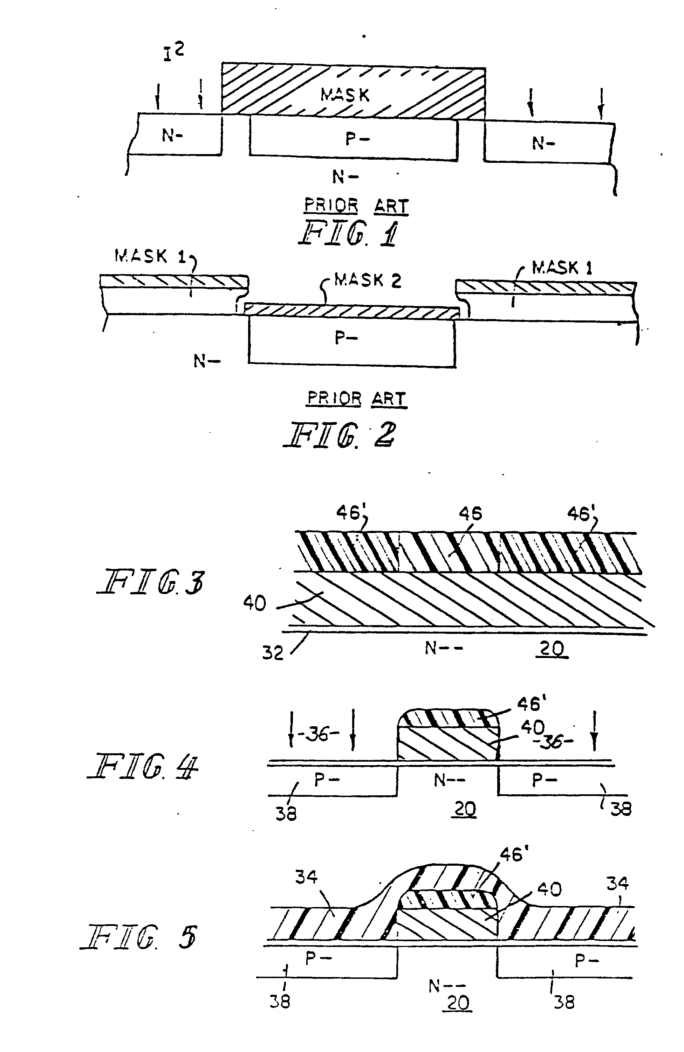

In more advanced processes, devices are more sensitive to their well dopings and profiles so that two implant masks are needed to tailor the wells of each type of transistor. When a second masking step is used for twin wells, alingment tolerance must be included to prevent overlapping of implants. As illustrated in Figure 1, the mask, which is the second mask, extends past the edges of the first P type impurity well and thus, is greater than the opening in the first mask of Figure 1. The size of the second mask is limited by the lithographic tolerances since overlap of the P-and N- regions is very undesirable.

The prior art has attempted to use silicon nitride mask and local oxidation to form a pair of masks using a single photolithographic process. In this process the first mask is silicon nitride and the second mask is the thick local oxidation which is an attempt at an inverse image of the silicon nitride. As is well known in the art, a bird's beak is formed, thus diminishing the accuracy of the mask alignments. Similarly, because of the high temperature cycle to form the local oxidation, undesirable redistribution of the first implant also results. Thus, this process has been found undesirable.

One technique to form a substantially reversed mask using one photolithographic step is to apply a thin metal layer over a thick photosensitive resist layer and selectively remove the photoresist layer with the thin metal layer thereon. Such processes involve a photoresist pattern with aspect ratio and treatment to the surface of the photoresist to give it an overhanging or undercut profile as a first mask. When metal as a second mask is deposited over this structure it will not be continuous over the step or a microcrack over the step will result. This discontinuity of metal or microcrack allows a wet chemical to attack the photoresist and lift off the unwanted metal. Because of the difference in height between the thickness of the metal layer and the photosensitive resist layer, a clean edge is not formed and, thus, some misalignment must be accounted for. Prior techniques generally use channel stops to account for any misalignment. This additional area occupies valuable space. A portion of the reverse masking step is illustrated in Figure 2 after the implant using the first mask and the application of the thin second mask layer prior to the removal of the first mask layer and the superimposed second mask material.

Although all of these problems have been addressed singly by the prior art, the industry is continuously searching for complete process flows which address as many of these problems as possible. Thus, it is an object of the present invention to address as many of the design restraints as possible while increasing the density of the devices on a chip.

It is known (IMB TDB vol. 25 no. 6, Nov. 1982, p. 2730) to form a first mask, to apply a second mask covering said first mask and an opening therein, to remove said second mask sufficiently to reveal a portion of said first mask and to remove said first mask, thus obtaining a reverse pattern of the first mask. This method also includes a planarization process by which planarization material is applied and the resulting structure is removed before selectively removing the first mask.

It is also known (EP-A 0 054 259) to form a gate on an insulating layer, to implant ions, to form insulative spacers, to implant ions again, to deposit a silicide forming material, to heat the resulting structure and to remove the unreacted material from oxide regions.

Thus, it is an object of the present invention to provide an improved unique process for forming a truly reverse image mask.

Another object of the present invention is to provide a reverse image masking technique which allows the formation of truly self-aligned twin wells.

Still another object of the present invention is to provide a single photolithographic step, reverse masking technique which produces self-aligned twin wells.

Yet another object of the present invention is to minimize latch-up.

A further object of the present invention is to provide a process which allows tailoring of the threshold of the devices.

An even further object of the present invention is to inhibit hot electron and substrate current injection.

A still even further object of the present invention is to provide a reduced resistance of junction in contacts.

Another object of the present invention is to lower the overall capacitance of the integrated circuit.

These and other objects of the invention are attained by a method of fabricating self-aligned regions according to claim 1. For further forming complementary insulated gate field effect transistors a gate insulative layer and gate materials are formed on two well areas. This is followed by forming shallow source and drain regions using the gate as a mask in each of the wells. Next, insulative spacers are formed extending laterally from the first and second gates over the source and drain regions and impurities are introduced to form deeper source and drain regions using the gate and the spacers as a mask. This is followed by the forming of the contacts to the respective layers. The gate material is polycrystalline silicon and the impurity introduction steps are carried out by ion implantation. A metal silicide step is performed to reduce the contact resistance by forming metal silicide over the source and drain regions as well as the gate. Insulative inserts are formed between the device regions by etching and filling by deposition to form planar oxide inserts separating the device regions laterally.

The removal of the third mask material to reveal the second mask material may be achieved by removing the third mask layer to reveal at least the edges of the openings in the second mask layer. This reduces the amount of removal processing.

The three mask layers must be of materials with sufficiently different characteristics such that they may be selectively removed. For example, the three mask layers may be selected from positive and negative photosensitive resist materials or photoresist materials and a metallic material. Where two types of photosensitive resist material are used, one mask is formed using a positive photosensitive resist wherein the mask layer is the unexposed portion after developing. After the introduction of impurities, and before the application of the next mask material, the remaining photoresist mask layer is radiation treated to form a hardened mask layer. The next mask layer, after being applied, is removed to reveal at least portions of the hardened mask material which is then selectively removed with any superimposed portion of the next mask layer thereon. This forms the inverse mask. The next mask material may either be a positive or negative photoresist mask since the radiation treated and hardened portion of the first photoresist mask can be selectively removed even with the same photosensitive resist material used in the second photoresist layer. If it is negative photosensitive resist, radiation treatment may not be necessary.

Other objects, advantages and novel features of the present invention will become apparent from the following detailed description of the invention when considered in conjunction with the accompanying drawings.

BRIEF DESCRIPTION OF THE DRAWINGS

Figure 1
illustrates the second mask of a two step photolithographic process of the prior art.
Figure 2
illustrates one stage in the formation of the second mask using a single photolithographic process of the prior art.
Figures 3 to 8
illustrate a method of forming an inverse mask according to the principles of the present invention.
Figures 9 to 15
illustrate the remainder of the process incorporating the principles of the present invention.
Figures 16 to 19
illustrate a modification of the process of Figures 9 to 12.

DETAILED DESCRIPTION OF THE DRAWINGS

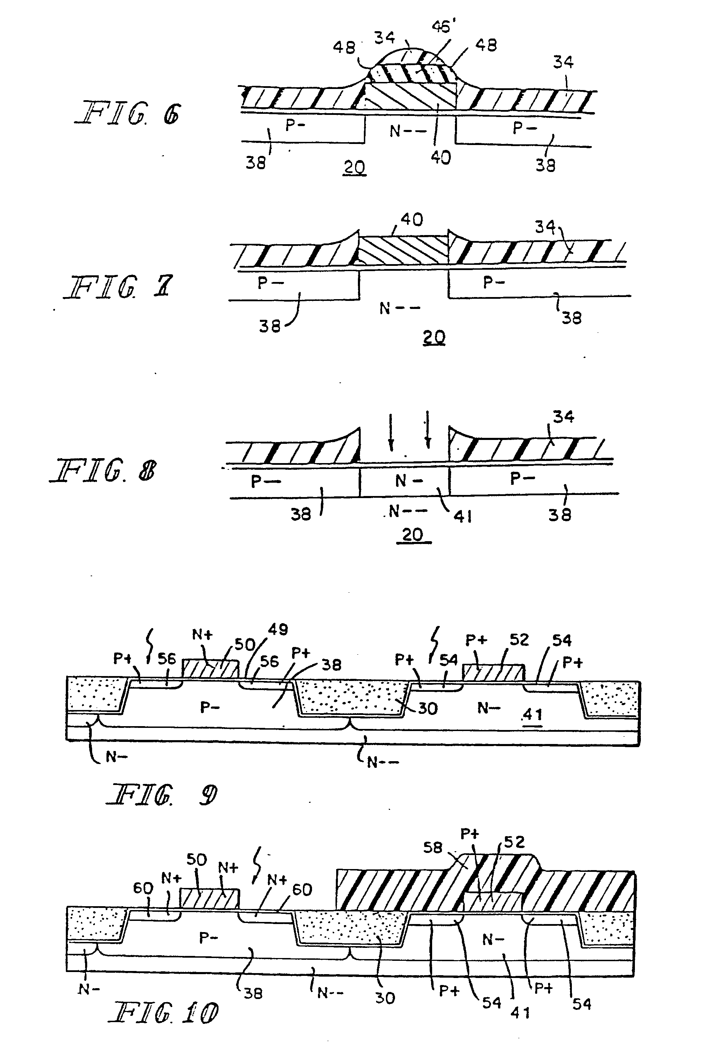

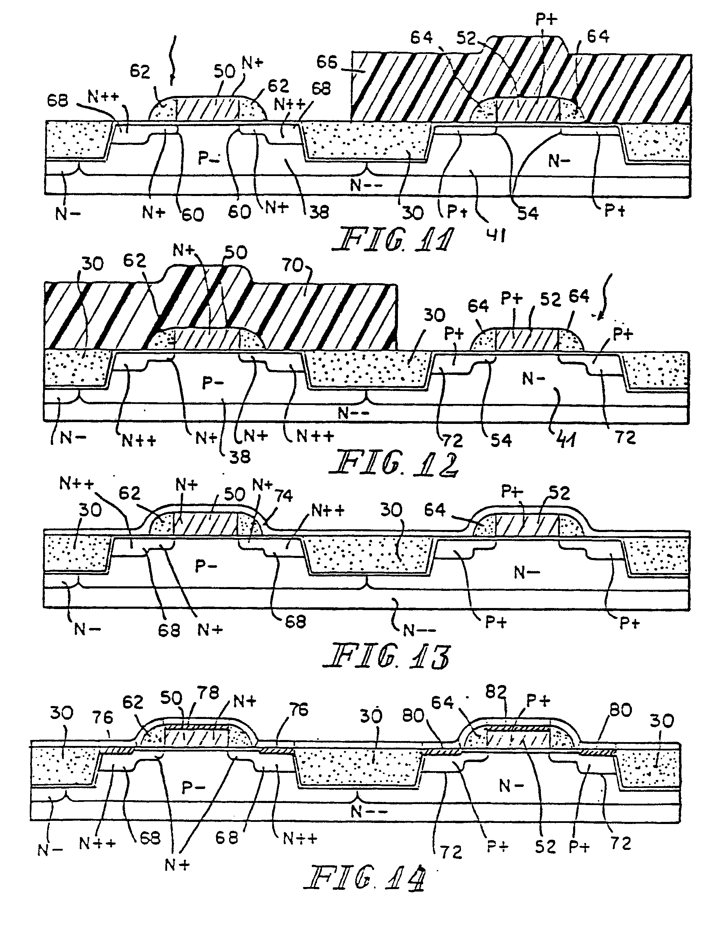

A method of forming the inverse mask is illustrated in Figures 3 to 8. The first mask material will be a metal mask for example, aluminium, and the second mask material will be the photoresist mask. Also, it will be noted that the technique is used on a substrate having no lateral dielectric isolation. The process begins by forming a first masking layer for example, a metal layer (40), on the top surface of the substrate (20) and separated therefrom by thin oxide layer (32). A thin photoresist material (46) having a thickness in the range of 0.5-1.5 μm (5,000 to 15,000 Angstroms) is then applied to the metal (40) and exposed to a desired pattern to form exposed regions (46') and unexposed regions (46). The structure is illustrated in Figure 3. The exposed portions (46') are then removed by a positive developer. The process so far has been described for a positive photoresist wherein the exposed portions are removed. The unexposed photoresist layer (46) is then used as a mask for the removal by etching of the metal layer (40). This etching may be performed by wet or dry etching as well as reactive ion etching. If a wet etch is used, the resultant side walls should be vertical to preserve the self-aligning effect. The resulting structure as illustrated in Figure 4 is a two-layer mask having photoresist portion (46) and metal portion (40). P type impurities for example, boron are introduced using the first mask layer as an alignment mask to form the P-wells (38).

Prior to the application of the second masking level, the photoresist layer (46) is exposed to for example, deep ultraviolet light to form a hard exposed photoresist. Depending upon the specific second mask material, the hardening step may not be necessary to prevent intermixing of the photoresists. This exposure may take place any time after the selective removal of the previous exposed portions (46') of Figure 3 and the application of the second mask layer. The second mask layer (34) is applied as illustrated in Figure 5. For example, a second mask layer may be a negative photoresist material. The second photoresist material is applied to a sufficient thickness so as to at least fill the openings (36) in the first mask level. This height should be at least to the height of the first mask level (40) and preferably to the combination of the height of the first mask level (40) and the photoresist level (46').

The second mask level (34) is removed until the edges (48) of the photoresist layer (46') are revealed as illustrated in Figure 6. The photoresist layer (46') is then selectively removed using an appropriate wet or dry etchant and the superimposed portion of the second photoresist layer (34) is also removed. The resulting structure is illustrated in Figure 7 wherein the first mask level (40) is surrounded laterally by the second mask level (34). The first mask level (40) may be selectively removed resulting in the mask of Figure 8. N type impurities for example, phosphorus are introduced to form the N- well region (41).

The processes for Figures 3 to 8 use a positive photoresist as a first masking layer and a negative photoresist as the second masking layer. This is the preferred embodiment since the positive photoresist, having an exposed pattern more easily removed than the unexposed pattern, allows for a subsequent exposure step prior to the formation of the second mask. This exposure step will prevent and reduce intermixing of the positive and negative photoresist to assure a true inverse masking operation. Depending upon the photoresist material used, the exposure hardening step may be deleted.

It should be noted that the photoresist material forming the second mask is never exposed so as to change character since it is used as an impurity introduction mask patterned by a lift-off style technique. Thus, a single photoresist material may be used for both the first and second mask. For example, the first mask (46) may be a positive photoresist wherein the exposed portions are removed by developer and followed by ion implantation. The unexposed portion is then exposed and new positive photoresist material may be applied to form the region (34). Since the first mask region (46') is an exposed photoresist, it has different characteristics than the unexposed second positive photoresist layer (34) and, thus, they can be selectively removed by developer.

The present process may be performed with any combination of photoresist as long as they have sufficiently different characteristics such that the first mask can be selectively removed with the overlying second mask.

Complementary insulated gate field effect transistors are formed by forming a gate oxide layer (49) on the surface of the substrate by, for example, exposing the substrate to an oxidizing atmosphere followed by the application of a gate material and delineation to form gate regions (50) and (52). In the preferred embodiment, the gates (50) and (52) are made from polycrystalline silicon. A first type P impurity, for example boron, is ion implanted non-selectively using the gates (50) and (52) and the oxide inserts (30) as a mask to produce shallow regions (56) in well (38) and shallow regions (54) in well (41) as illustrated in Figure 9.

A mask is formed by applying photoresist layer (58) and delineating to mask the N- well region (41) and expose the P-well region (38). N-type impurities, for example arsenic, are implanted using the mask (58) and the gate (50) in combination with oxide inserts (30) to form shallow N+ source and drain regions (60). The ion implantation is carried out at a sufficient level to overcome the original P+ regions (56) in well (38). The initial introduction of P+ impurities into the P- well (38) allows for greater range for the formation of the N+ source and drain regions (60). The resulting structure is illustrated in Figure 10. The mask layer (58) is removed. The structure at this point has shallow source and drain regions formed in each of the complementary field effect transistor wells having a depth in the range of 100-200 nm (1000 to 2000 Angstroms) and an impurity concentration in the range of $10^{18}$ to $10^{19}$ atoms per cubic centimeter.

The next sequence of operation form the deep source and drain region portions. This process begins with the formation of spacers extending laterally from the gate regions (50) and (52). These spacers are formed by depositing an insulative layer, for example chemical vapor deposition of silicon dioxide over the surface of the substrate. The oxide layer is then reactive ion etched to form the spacer regions (62) extending from gate (50) and spacers (64) extending from gate (52). These spacers result from the uneven topology of the deposited silicon oxide layer. This process is well known in the prior art and, thus, is not described in detail.

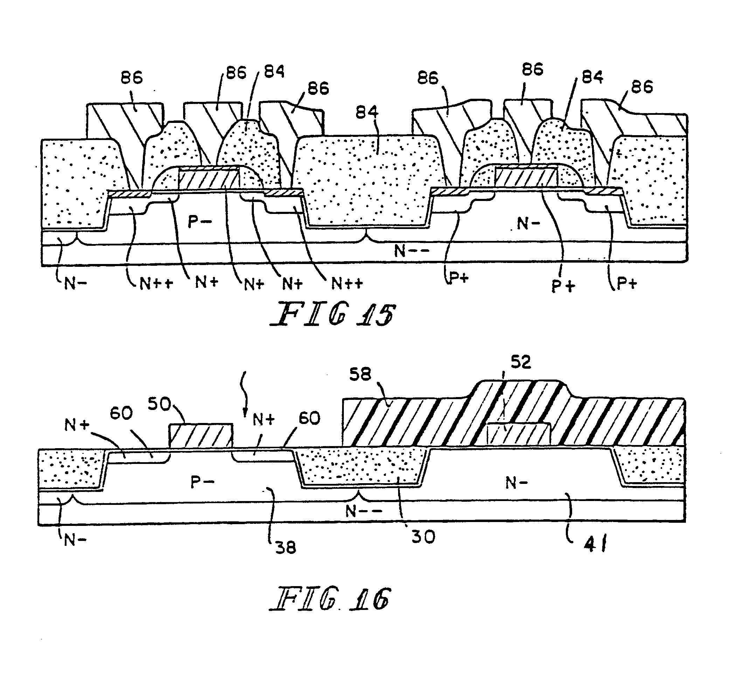

After formation of the spacers, a masking layer (66) is applied over the substrate and delineated to mask N- well region (41) and expose P- well region (38). N+ impurities, for example phosphorus, are ion implanted using the mask layer (66), the gate (50) and the spacers (62) as well as inserts (30) as a mask. This results in deep N+ source and drain regions (68) extending laterally from the shallow N+ source and drain regions (60) as illustrated in Figure 11. The masking layer (66) is removed and a new masking layer (70) is applied and delineated to expose well (41) and mask well (38). P-type impurities, for example boron, are ion implanted using the mask layer (70), the gate (52), spacers (64) and the oxide inserts (30) as alignment mask. This results in the deep P+ source and drain regions (72) extending laterally from the shallow source and drain regions (54) as illustrated in Figure 12 having a depth in the range of 300-400 nm (3000 to 4000 Angstroms) and an impurity concentration in the range of $10^{18}$ to $10^{20}$ atoms per cubic centimeter. The photoresist layer (70) is removed. This completes the device formation steps.

It is evident from Figure 12 that the polycrystalline gates (50) and (52) are of a lower resistance and are doped as N+ and P+ respectively having an impurity concentration in the range of $10^{18}$ to $10^{20}$ atoms per cubic centimeter.

The formation of the field oxide and the contacts is the final processing sequence. In order to reduce the junction resistance and provide barrier metal for shallow junctions, a silicide forming metal layer (74) is applied to the substrate as illustrated in Figure 13. This layer may be, for example platinum. The wafer is then heated to cause platinum silicide to form in those regions where the platinum contacts the polycrystalline silicon gate or the silicon substrate. As illustrated in Figure 14, this includes the platinum silicide regions (76) on deep source and drain regions (68), region (78) on gate (50), regions (80) on deep source and drain regions (72) and region (82) on gate (52). No platinum silicide is formed over the oxide inserts (30) or the spacers (62) and (64). The portions of the platinum which should not form platinum silicide is easily selectively removed using for example hot concentrated Aqua Regia.

The use of the oxide spacers inhibit hot electron and substrate current injection as well as providing better gate oxide reliability. Used in combination with the metal forming silicides, a self-alignment technique for the silicide formation without a mask results. The spacers also smooth out the sharp edges of the gate material for better contact metal coverage.

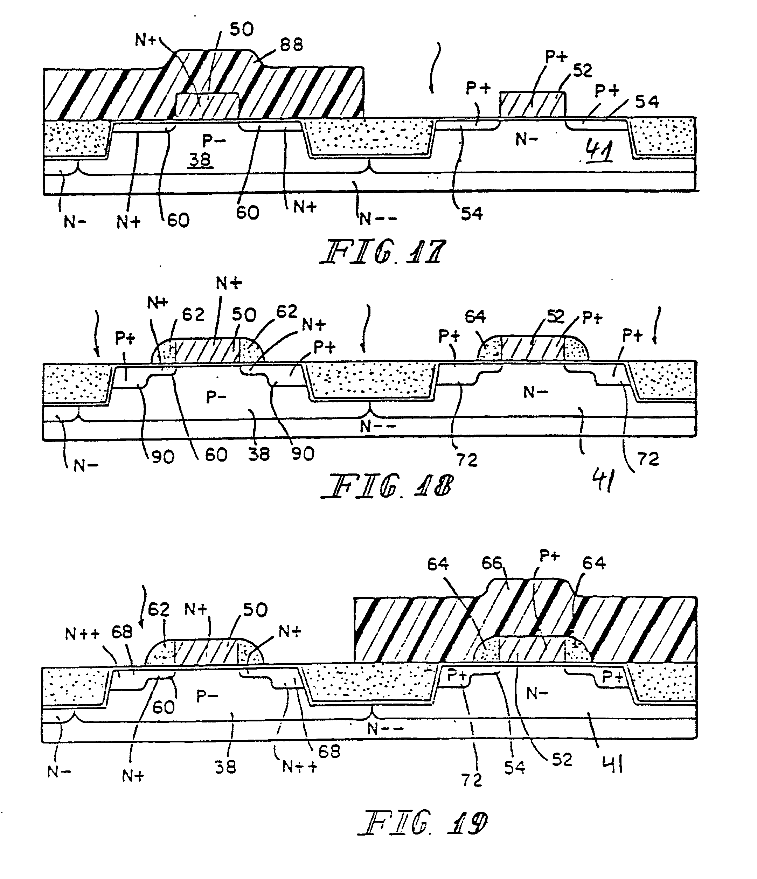

A field oxide layer (84) is then formed over the wafer by chemical vapor deposition for example and vias are etched to provide contacts to the platinum silicide portion of the source and drain regions and the gate regions. A layer of contact metal is then applied and delineated to form contacts (86). The resulting structure is illustrated in Figure 15. An insulative layer may be provided over the first metal layer (86) and a second layer of metal provided.

An alternative method for forming the shallow and deep source and drain regions includes, as illustrated in Figure 16, forming the masking layer (58) blocking the N- well region (41) and exposing the P-well region (38). The N+ arsenic implant is performed to form shallow source and drain regions (60). The photoresist layer (58) is removed and a photoresist layer (88) is applied and delineated to form a mask layer blocking the P-well region (38) and exposing the N- well region (41). P+ type impurities are implanted to form the P+ source and drain regions (54) as illustrated in Figure 17. The masking layer (88) is removed and a non-selective p-type boron implant is performed forming deep P+ source and drain regions (72) and P+ source and drain regions (90) in wells (41) and (38) respectively as illustrated in Figure 18. A masking layer (66) is applied and delineated to expose the P- well region (38) and block the N- well region (41). N-type impurities, for example phosphorus, are implanted to form the deep N+ source and drain regions (68). This implantation must be carried out at sufficient power levels to overcome the P+ regions (90) originally formed in the prior step. The resulting structure is illustrated in Figure 19. The mask layer (66) is removed and the process is continued as previously described for Figures 13 to 15.

The process of Figures 16 to 19 is substantially similar to the process steps of Figures 9 to 12 in that three masking steps are used for four implantations to form the two part source and drain regions for complementary insulated gate field effect transistors. This results since one of the implantation or doping step is performed non-selectively. The difference is, in Figures 9 to 12, the non-selective implantation is at the beginning of the process, whereas in the process of Figures 16 to 19, the non-selective implantation is in the middle of the process. As can be noted, the implantation of the P and N source and drain regions have been reversed in the two process flows. Since all the impurity introduction is by low temperature ion implantation, it is not critical that the N implantation precede the P implantation. The importance of the sequence of steps is that the shallow source and drain regions are formed using the gate as the alignment mask and that the deeper regions are formed using the spacer as the alignment mask.

**Claims**

1. A method of fabricating self-aligned regions in a substrate (20) comprising:
   forming a first mask layer (40) of a first material on said substrate (20);
   applying a second mask layer (46) of a second material with at least one opening therein on said first mask layer (40);
   removing a portion of said first mask layer (40) in said second mask layer opening to form a first mask by forming an opening (36) to reveal said substrate;
   introducing impurities of a first conductivity type into said substrate (20) through said opening (36) in said first and second mask layer to form a first well region (38);
   applying a third mask layer (34) of a third material to at least fill said opening (36) in said first mask;
   removing said third mask layer (34) until a portion of said second mask layer (46') is revealed;
   selectively removing said second mask layer (46') with any superimposed third layer (34) to reveal said first mask layer (40);
   selectively removing said first mask layer (40) to form a second mask, the reverse image of said first mask; and
   introducing impurities of a second conductivity type into said substrate (20) through openings in said second mask to form second well regions (41) aligned with said first well regions (38).

2. A method according to Claim 1 wherein said second and third materials (46, 34) are different photosensitive resist materials.

3. A method according to Claim 1 or 2 wherein said first material (40) is a metallic material and said second material (46) is a photosensitive resist material.

4. A method according to Claim 1 or 2 wherein said second mask layer (46) is formed to have a thickness in the range of 500 to 1500 nm.

5. A method according to Claim 1 or Claim 4 wherein said third mask layer (34) is applied to a thickness at least equal to the thickness of said first mask layer (40).

6. A method according to Claim 1 wherein said second material (46) is a positive photosensitive resist material and including exposing said second mask layer (46) after forming said opening (36) in said first mask layer (40) and before applying said third mask layer (34).

7. A method according to Claim 1 including forming complementary insulated gate field effect transistors further comprising:
   forming a gate insulative layer (49) on said substrate; forming first and second gates (50, 52) on said gate insulative layer (49) over said first and second wells (38, 41), respectively;
   introducing second conductivity type impurities into said first well (38) using said first gate (50) as a mask to form shallow source and drain regions (60);
   introducing first conductivity type impurities into said second well (41) using said second gate (52) as a mask to form shallow source and drain regions (54);
   forming insulative spacers (62, 64) extending lateral from said first and second gates (50, 52) over said source and drain regions;
   introducing first conductivity type impurities into said second well (41) using said second gate (52) and spacers (64) as a mask to form deep source and drain regions (72) having a greater depth than said shallow source and drain regions; and
   introducing second conductivity type impurities into said first well (38) using said first gate (50) and spacers (62) as a mask to form deep source and drain regions (68) having a greater depth than said shallow source and drain regions.

8. A method according to Claim 7 wherein said first and second gates (50, 52) and said substrate are formed of silicon; and further including forming oxide regions (30) between said wells (38, 41) before forming said source and drain regions,
   non-selectively forming a silicide forming material (74) over said substrate after forming said deep source and drain regions,
   heating to form a metal silicide (76, 78, 80, 82) on said gate and source and drain regions, and
   removing said silicide forming material from said spacers (62, 64) and oxide regions (30).

9. A method according to Claim 7 wherein:

introducing impurities to form said shallow source and drain regions (54) in said second well (41) is performed using said gates (50, 52) only as a mask;

introducing impurities to form said shallow source and drain regions (60) in said first well (38) includes forming a mask (58) covering said second well (41);

introducing impurities to form said deep source and drain regions (72) in said second well (41) includes forming a mask (70) covering said first well (38); and

introducing impurities to form said deep source and drain regions (68) in said first well (38) includes forming a mask (66) covering said second well (41).

10. A method according to Claim 7 wherein:

introducing impurities to form said shallow source and drain regions (60) in said first well (38) includes forming a mask (58) covering said second well (41);

introducing impurities to form said shallow source and drain regions (54) in said second well (41) includes forming a mask (88) covering said first well (38);

introducing impurities to form said deep source and drain regions (72) in said second well (41) is performed using said gate (52) only as a mask; and

introducing impurities to form said deep source and drain regions (68) in said first well (38) includes forming a mask (66) covering said second well (41).

**Revendications**

1. Un procédé de fabrication de régions auto-alignées sur un substrat (20) comprenant :

la formation d'une première couche de masque d'un premier matériau sur ledit substrat (20);

l'application d'une seconde couche de masque (46) sur un second matériau avec, au moins, une ouverture intérieure sur ladite première couche de masque (40);

l'enlèvement d'une partie de ladite première couche de masque (40) dans l'ouverture de la seconde couche de masque pour former un premier masque en formant une ouverture (36) pour faire apparaître substrat;

l'introduction d'impuretés d'un premier type de conductibilité dans ledit substrat (1) à travers ladite ouverture (36) dans lesdites première et seconde couches de masque pour former une première région de puits (38);

l'application d'une troisième couche de masque (34) d'un troisième matériau de manière au moins à remplir ladite ouverture (36) du premier masque;

l'enlèvement dudit troisième masque ladite couche de troisième masque (34) jusqu'à ce qu'une partie de la couche du second masque (46') apparaisse;

l'enlèvement sélectif de ladite seconde couche de second masque (46') et de la troisième couche superposée (34) pour faire apparaître ladite première couche de masque (40);

l'enlèvement sélectif de ladite première couche de masque (40) pour former un second masque constituant l'image inversée dudit premier masque; et

l'introduction d'impuretés d'un second type de conductibilité dans ledit substrat (1) à travers les ouvertures dudit second masque de manière à former des secondes régions du puits (41) alignées avec lesdites premières régions du puits (38).

2. Procédé selon la revendication 1 dans lequel lesdits second et troisième matériaux (46, 34) sont des matériaux photosensibles résistants.

3. Procédé selon les revendications 1 ou 2 dans lequel ledit premier matériau (40) est un métal et en ce que ledit second matériau (46) est un matériau photosensible résistant.

4. Procédé selon l'une des revendications 1 ou 2 dans lequel ladite seconde couche de masque (46) est formée de manière à avoir une épaisseur de 500 à 1 500 nm.

5. Procédé selon l'une des revendications 1 ou 4, caractérisé en ce que ladite troisième couche masque (34) est appliquée sur une épaisseur au moins égale à l'épaisseur de ladite première couche de masque (40).

6. Procédé selon la revendication 1 dans lequel ledit second matériau (46) est un matériau positif photosensible résistant, incluant l'exposition de ladite seconde couche de masque (46) après formation de ladite ouverture (36) dans la première couche de masque (40) et avant l'application de la troisième couche de masque (34).

7. Procédé selon la revendication 1 incluant la formation de transistors à effet de champ à porte isolée comprenant de plus :

la formation d'une couche de porte isolante (49) sur ledit substrat;

la formation de première et seconde porte (50) et (52) sur ladite couche (49) isolante de porte au-dessus des premier et second puits (38, 41) respectivement;

l'introduction d'impuretés d'un second type de conductibilité dans ledit premier puits (38) en utilisant ladite première porte (50) en tant que masque pour former les régions élevées de source et de drain (60);

l'introduction d'impuretés d'un premier type de conductibilité dans ledit second puits (41) en utilisant ladite seconde porte (52) en tant que masque pour former des régions (54) élevées de source et de drain;

la formation d'espacements isolants (62, 64) s'étendant latéralement à partir desdites première et seconde portes (50, 52) au-dessus desdites régions de source et de drain;

l'introduction d'impuretés du premier type de conductibilité dans ledit second puits (41) en utilisant ladite seconde porte (52) et les espacements (54) en tant que masque pour former les régions profondes (72) de source et de drain ayant une profondeur plus grande que les régions élevées de source et de drain; et

l'introduction d'impuretés de second type de conductibilité dans ledit premier puits (38) en utilisant ladite première porte (50) et les espacements (62) en tant que masque pour former les régions profondes (68) de source et de drain ayant une profondeur plus grande que celle des régions élevées de source et de drain.

8. Procédé selon la revendication 7 dans lequel lesdites première et seconde porte (50, 52) et ledit substrat sont formés de silicium et de plus inclut

la formation de régions d'oxyde (30) entre lesdits puits (38, 41) avant la formation desdites régions de source et de drain;

la formation non sélective d'un siliciure d'un matériau formant du siliciure (74) au-dessus dudit substrat après formation desdites régions profondes de source et de drain;

le chauffage de manière à former un siliciure métallique (76, 78, 80, 82) sur lesdites régions de porte, de source et de drain; et

l'extraction dudit matériau formant des siliciures à partir des espacements (62, 64) et dans les régions d'oxyde (30).

9. Procédé selon la revendication 7 dans lequel :

l'introduction des impuretés pour former lesdites régions élevées de source et de drain (54) dans ledit second puits (41) est effectuée en utilisant les portes (50, 52) seulement en tant que masque;

l'introduction d'impuretés pour former les régions élevées de source et de drain (60) dans ledit premier puits (38) inclut la formation d'un masque (58) couvrant ledit second creux (41);

l'introduction d'impuretés pour former lesdites régions profondes (72) de source et de drain dans ledit second puits (41) inclut la formation d'un masque (70) couvrant ledit premier puits (38); et

l'introduction d'impuretés pour former lesdites régions profondes de source et de drain (68) dans ledit premier puits (38) inclut la formation d'un masque (66) couvrant le second creux (41).

10. Procédé selon la revendication 7 dans lequel :

l'introduction des impuretés pour former lesdites régions élevées de source et de drain dans ledit premier puits (38) inclut la formation d'un masque (58) couvrant ledit second puits (41);

l'introduction d'impuretés pour former lesdites régions élevées de source et de drain (54) dans ledit second puits (41) inclut la formation d'un masque (88) couvrant ledit premier puits (38);

l'introduction d'impuretés pour former lesdites régions profondes (72) de source et de drain dans ledit second puits (41) est effectuée en utilisant ladite porte (52) seulement en tant que masque; et

l'introduction d'impuretés pour former lesdites régions profondes de source et de drain (68) dans ledit premier puits (38) inclut la formation d'un masque (66) couvrant ledit second puits (41).

**Patentansprüche**

1. Verfahren zum Herstellen selbstjustierter Bereiche in einem Substrat (20), bei dem
eine erste Maskenschicht (40) eines ersten Materials auf das Substrat (20) aufgebracht wird,
eine zweite, zumindest eine Öffnung enthaltende Maskenschicht (46) eines zweiten Materials auf die erste Maskenschicht (40) aufgebracht wird,
ein Teil der ersten Maskenschicht (40) in der Öffnung der zweiten Maskenschicht entfernt und damit durch Ausbildung einer das Substrat freilegenden Öffnung (36) eine erste Maske hergestellt wird,
Verunreinigungen eines ersten Leitfähigkeitstyps durch die Öffnung (36) in der ersten und der zweiten Maskenschicht in das Substrat (20) eingebracht werden, zur Ausbildung eines ersten Senken-Bereichs (38),

eine dritte Maskenschicht (34) eines dritten Materials so aufgebracht wird, daß zumindest die Öffnung (36) in der ersten Maske ausgefüllt wird,

die dritte Maskenschicht (34) entfernt wird, bis ein Teil der zweiten Maskenschicht (46') freiliegt,

die zweite Maskenschicht (46') mit einer eventuell darüberliegenden dritten Schicht (34) selektiv entfernt und dadurch die erste Maskenschicht (40) freigelegt wird,

die erste Maskenschicht (40) selektiv entfernt und dadurch eine zweite Maske als Kehrbild der ersten Maske ausgebildet wird und

Verunreinigungen eines zweiten Leitfähigkeitstyps durch Öffnungen in der zweiten Maske in das Substrat (20) eingebracht werden, zur Ausbildung zweiter, mit den ersten Senken-Bereichen (38) ausgerichteter Senken-Bereiche (41).

2. Verfahren nach Anspruch 1, bei dem die zweiten und dritten Materialen (46, 34) unterschiedliche photoempfindliche Lacke sind.

3. Verfahren nach Anspruch 1 oder 2, bei dem das erste Material (40) ein metallisches Material und das zweite Material (46) ein photoempfindlicher Lack ist.

4. Verfahren nach Anspruch 1 oder 2, bei dem die zweite Maskenschicht (46) mit einer Stärke im Bereich von 500 bis 1500 nm aufgebracht wird.

5. Verfahren nach Anspruch 1 oder 4, bei dem die dritte Maskenschicht (34) mit einer Stärke mindestens gleich der Stärke der ersten Maskenschicht (40) aufgebracht wird.

6. Verfahren nach Anspruch 1, bei dem das zweite Material (46) ein positiver photoempfindlicher Lack ist und die zweite Maskenschicht (46) nach Ausbildung der Öffnung (36) in der ersten Maskenschicht (40) und vor dem Aufbringen der dritten Maskenschicht (34) belichtet wird.

7. Verfahren nach Anspruch 1, das die Ausbildung von Isolierschicht-Feldeffekttransistoren beinhaltet und bei dem ferner

eine Gatter-Isolierschicht (49) auf dem Substrat ausgebildet wird, erste und zweite Gatter (50, 52) auf der Gatter-Isolierschicht (49) jeweils über der ersten und der zweiten Senke (38, 41) ausgebildet werden,

Verunreinigungen eines zweiten Leitfähigkeitstyps mit Hilfe des ersten Gatters (50) als Maske in die erste Senke (38) eingeführt und damit flache Quellen- und Senkenbereiche (60) ausgebildet werden,

Verunreinigungen eines ersten Leitfähigkeitstyps mit Hilfe des zweiten Gatters (52) als Maske in die zweite Senke (41) eingeführt und damit flache Quellen- und Senkenbereiche (54) ausgebildet werden,

isolierende Abstandsschichten (62, 64) seitlich der ersten und zweiten Gatter (50, 52) über den Quellen- und Senkenbereichen ausgebildet werden,

Verunreinigungen eines ersten Leitfähigkeitstyps mit Hilfe des zweiten Gatters (52) und der Abstandsschichten (64) als Maske in die zweite Senke (41) eingeführt werden zur Ausbildung tiefer Quellen- und Senkenbereiche (72), die eine größere Tiefe aufweisen als die flachen Quellen- und Senkenbereiche, und

Verunreinigungen eines zweiten Leitfähigkeitstyps mit Hilfe des ersten Gatters (50) und der Abstandsschichten (62) als Maske in die erste Senke (38) eingeführt werden zur Ausbildung tiefer Quellen- und Senkenbereiche (68), die eine größere Tiefe aufweisen als die flachen Quellen- und Senkenbereiche.

8. Verfahren nach Anspruch 7, bei dem die ersten und zweiten Gatter (50, 52) und das Substrat aus Silizium bestehen und bei dem ferner vor Ausbildung der Quellen- und Senkenbereiche Oxidbereiche (30) zwischen den Senken (38, 41) ausgebildet werden,

nach der Ausbildung der tiefen Quellen- und Senkenbereiche über dem Substrat in nicht selektiver Weise ein silicidbildendes Material (74) aufgebracht wird,

durch Erhitzen ein Metall-Silicid (76, 78, 80, 82) auf den Gattern und Quellen- und Senkenbereichen ausgebildet wird und

das silicidbildende Material von den Abstandsschichten (62, 64) und den Oxidbereichen (30) entfernt wird.

9. Verfahren nach Anspruch 7, bei dem das Einbringen der Verunreinigungen zur Ausbildung der flachen Quellen- und Senkenbereiche (54) in der zweiten Senke (41) nur mittels der Gatter (50, 52) als Maske erfolgt,

das Einbringen von Verunreinigungen zur Ausbildung der flachen Quellen- und Senkenbereiche (60) in der ersten Senke (38) den Schritt umfaßt, eine die zweite Senke (41) abdeckende Maske (58) auszubilden,

das Einbringen von Verunreinigungen zur Ausbildung der tiefen Quellen- und Senkenbereiche (72) in der zweiten Senke (41) den Schritt umfaßt, eine die erste Senke (38) abdeckende Maske (70) auszubilden, und

das Einbringen von Verunreinigungen zur Ausbildung der tiefen Quellen- und Senkenbereiche (68) in der ersten Senke (38) den Schritt umfaßt, eine die zweite Senke (41) abdeckende Maske (66) auszubilden.

10. Verfahren nach Anspruch 7, bei dem
das Einbringen von Verunreinigungen zur Ausbildung der flachen Quellen- und Senkenbereiche (60) in der ersten Senke (38) den Schritt umfaßt, eine die zweite Senke (41) abdeckende Maske (58) auszubilden,

das Einbringen der Verunreinigungen zur Ausbildung der flachen Quellen- und Senkenbereiche (54) in der zweiten Senke (41) den Schritt umfaßt, eine die erste Senke (38) abdeckende Maske (88) auszubilden,

das Einbringen von Verunreinigungen zur Ausbildung der tiefen Quellen- und Senkenbereiche (72) in der zweiten Senke (41) nur mittels des Gatters (52) als Maske erfolgt und

das Einbringen von Verunreinigungen zur Ausbildung der tiefen Quellen- und Senkenbereiche (68) in der ersten Senke (38) den Schritt umfaßt, eine die zweite Senke (41) abdeckende Maske (66) auszubilden.

I²

MASK

N—    P—    N—

N—

PRIOR ART

FIG. 1

MASK 1    MASK 2    MASK 1

P—

N—

PRIOR ART

FIG. 2

FIG.3

46'    46    46'

40

32    N——    20

FIG. 4

-36-    46'    40    -36-

P—    N——    P—

38    20    38

FIG. 5

34    46'    40    34

P—    P—

38    N——    38
20

FIG. 6

FIG. 7

FIG. 8

FIG. 9

FIG. 10

EP 0 164 737 B1

FIG. 11

FIG. 12

FIG. 13

FIG. 14

13

*FIG 15*

*FIG. 16*

FIG. 17

FIG. 18

FIG. 19

15